# EUROPEAN PATENT APPLICATION

(11) **EP 3 534 208 A1**
(43) Date of publication of application: **04.09.2019**
(21) Application number: 17871712.0
(22) Date of filing: 17.02.2017
(51) Int. Cl.: G02F 1/1368

(54) **ARRAY SUBSTRATE AND PREPARATION METHOD THEREFOR, AND LIQUID CRYSTAL DISPLAY PANEL**

(30) Priority: 17.11.2016 CN 201611031257
(71) Applicant: Huawei Technologies Co., Ltd., Longgang District Shenzhen, Guangdong 518129 (CN)
(72) Inventor: LIANG, Yanfeng, Shenzhen Guangdong 518129 (CN)
(74) Representative: Gill Jennings & Every LLP
(86) International application number: PCT/CN2017/073990
(87) International publication number: WO 2018/090496

(57) **Abstract**

This application provides an array board and a production method thereof, and a liquid crystal display panel, and relates to the field of display technologies. Compared with the prior art, no current leakage path is generated, so that display uniformity can be improved. The array board includes a plurality of subpixels. Each subpixel includes a first thin film transistor, a pixel electrode, and a common electrode that are disposed on a substrate, and the pixel electrode is electrically connected to a drain electrode of the first thin film transistor by using a via hole. Each subpixel further includes an auxiliary electrode disposed at the via hole, the auxiliary electrode is disposed between the pixel electrode and the drain electrode of the first thin film transistor, and the pixel electrode is electrically connected to the drain electrode of the first thin film transistor by using the auxiliary electrode. The common electrode is disposed on one side that is of the pixel electrode and that is away from the substrate, and an orthographic projection of the common electrode on the substrate and an orthographic projection of the pixel electrode on the substrate do not overlap at the via hole. The array board is applied to a liquid crystal display apparatus.

## Description

This application claims priority to Chinese Patent Application No. 201611031257.9, filed with the Chinese Patent Office on November 17, 2016, and entitled "FFS LCD", which is incorporated herein by reference in its entirety.

### TECHNICAL FIELD

This application relates to the field of display technologies, and in particular, to an array board and a production method thereof, and a liquid crystal display panel.

### BACKGROUND

With rapid development of a thin film transistor (Thin Film Transistor, TFT for short) production technology, a liquid crystal display (Liquid Crystal Display, LCD for short) having advantages such as thinness, low power consumption, and no radiation has been widely applied to various electronic products such as a computer, a personal digital assistant (Personal Digital Assistant, PDA for short), a television, a digital camera, and a mobile phone.

Based on positions at which a pixel electrode and a common electrode in the liquid crystal display are disposed on an array board, the liquid crystal display may fall into two types: a fringe field switching (Fringe Field Switching, FFS for short) type and an in-plane switching (In Plane Switching, IPS for short) type. Compared with the IPS-type liquid crystal display, the FFS-type liquid crystal display has high transmittance, and implements high transmittance at a wide viewing angle. Therefore, an FFS technology is widely applied to the field of liquid crystal display technologies.

On the array board, the pixel electrode needs to be electrically connected to a drain electrode of a thin film transistor. Usually, after the drain electrode is formed, a via hole exposing the drain electrode is formed on an insulation layer, and then the pixel electrode is formed, so that the pixel electrode is electrically connected to the drain electrode by using the via hole. However, due to a technology change, a sharp corner usually appears at the via hole that connects the pixel electrode and the drain electrode. Consequently, there is a current leakage path between the subsequently formed pixel electrode and common electrode, and display non-uniformity occurs.

### SUMMARY

Embodiments of the present invention provide an array board and a production method thereof, and a liquid crystal display panel. Compared with the prior art, no current leakage path is generated, so that display uniformity can be improved.

To achieve the foregoing objective, the following technical solutions are used in the embodiments of the present invention:

According to a first aspect, an array board is provided, including a plurality of subpixels, where each subpixel includes a first thin film transistor, a pixel electrode, and a common electrode that are disposed on a substrate, and the pixel electrode is electrically connected to a drain electrode of the first thin film transistor by using a via hole. Each subpixel further includes an auxiliary electrode disposed at the via hole that connects the pixel electrode and the drain electrode of the first thin film transistor, where the auxiliary electrode is disposed between the pixel electrode and the drain electrode of the first thin film transistor, and the pixel electrode is electrically connected to the drain electrode of the first thin film transistor by using the auxiliary electrode. The common electrode is disposed on one side that is of the pixel electrode and that is away from the substrate, and an orthographic projection of the common electrode on the substrate and an orthographic projection of the pixel electrode on the substrate do not overlap at the via hole that connects the pixel electrode and the drain electrode of the first thin film transistor. The pixel electrode and the common electrode are stacked on the array board, so that when the array board is applied to a liquid crystal display panel, the liquid crystal display panel can have advantages such as high resolution, high transmittance, low power consumption, a wide viewing angle, a high aperture ratio, low chromatic aberration, and no push mura. In addition, the orthographic projection of the common electrode on the substrate and the orthographic projection of the pixel electrode on the substrate do not overlap at the via hole that connects the pixel electrode and the drain electrode of the first thin film transistor. Therefore, regardless of a technology change at the via hole, no current leakage path is generated because there is no common electrode at the via hole, so that when the array board is applied to a liquid crystal display panel, display uniformity can be improved.

In a first possible implementation of the first aspect, the first thin film transistor is a low-temperature polycrystalline silicon thin film transistor. Therefore, a liquid crystal display panel including the array board can have advantages such as high mobility, a high reaction speed, high resolution, high luminance, and a high aperture ratio.

With reference to the first possible implementation of the first aspect, in a second possible implementation of the first aspect, each subpixel further includes a second thin film transistor, the second thin film transistor is a low-temperature polycrystalline silicon thin film transistor, and the second thin film transistor and the first thin film transistor are connected in series. Two low-temperature polycrystalline silicon thin film transistors that are connected in series are disposed in each subpixel to drive the pixel electrode, so that driving performance of each subpixel can be improved.

With reference to the second possible implementation of the first aspect, in a third possible implementation of the first aspect, the first thin film transistor includes a first active layer, and the second thin film transistor includes a second active layer; the first active layer and the second active layer each include a source electrode region, a channel region, and a drain electrode region, and the source electrode region of the first active layer is connected to the drain electrode region of the second active layer; and the drain electrode of the first thin film transistor is in contact with the drain electrode region of the first active layer, a source electrode of the second thin film transistor is in contact with the source electrode region of the second active layer, and the source electrode of the second thin film transistor is electrically connected to a data line. Compared with a case in which a drain electrode of the second thin film transistor is electrically connected to a source electrode of the first thin film transistor (that the drain electrode of the second thin film transistor is connected to the source electrode of the first thin film transistor is only for transmitting, to the drain electrode of the first thin film transistor, a signal on the data line electrically connected to the source electrode of the second thin film transistor), in this embodiment of the present invention, the source electrode region of the first active layer is connected to the drain electrode region of the second active layer, so that the signal on the data line electrically connected to the source electrode of the second thin film transistor can be directly transmitted to the drain electrode of the first thin film transistor by using the first active layer and the second active layer that are connected, without producing the drain electrode of the second thin film transistor and the source electrode of the first thin film transistor. In this way, a production technology can be simplified, and costs are reduced.

With reference to the third possible implementation of the first aspect, in a fourth possible implementation of the first aspect, the first thin film transistor includes a first gate electrode, and the second thin film transistor includes a second gate electrode; and the first gate electrode is electrically connected to the second gate electrode. Therefore, the second thin film transistor and the first thin film transistor can be enabled at the same time, and line arrangement and a drive circuit on the array board can be simplified.

With reference to any one of the foregoing possible implementations, in a fifth possible implementation of the first aspect, the array board further includes a touch electrode and a touch electrode lead electrically connected to the touch electrode, the touch electrode lead and the auxiliary electrode are synchronously formed, and the auxiliary electrode and the touch electrode lead are insulated from each other. The touch electrode and the touch electrode lead electrically connected to the touch electrode are disposed on the array board, so that when the array board is applied to a liquid crystal display panel, the liquid crystal display panel can have a touch function. On a basis of this, the touch electrode lead and the auxiliary electrode are synchronously formed, so that a quantity of times of using a pattern forming technology can be reduced.

Further, the touch electrode includes a drive electrode and an induction electrode. The drive electrode extends in a first direction, the induction electrode extends in a second direction, and the first direction and the second direction are crossed. A touch electrode lead electrically connected to the drive electrode is configured to provide a touch drive signal for the drive electrode, and a touch electrode lead electrically connected to the induction electrode is configured to receive a touch induction signal induced by the induction electrode. In this way, a touch position can be identified in a mutual-capacitance manner.

Alternatively, touch electrodes are arranged into an array, and the touch electrode lead electrically connected to the touch electrode provides a touch drive signal for the touch electrode, and receives a touch induction signal induced by the touch electrode. In this way, a touch position can be identified in a self-capacitance manner.

With reference to the fifth possible implementation of the first aspect, in a sixth possible implementation of the first aspect, the touch electrode and the common electrode are interchangeable. In this way, the touch position can be identified in a self-capacitance manner, and a technology of producing the array board is simpler.

With reference to any one of the foregoing possible implementations, in a seventh possible implementation of the first aspect, the array board further includes a buffer layer that is disposed on a surface, of the substrate, on which the first thin film transistor, the pixel electrode, and the common electrode are disposed. The buffer layer is disposed on the surface of the substrate first, and then the first thin film transistor or even the second thin film transistor is disposed on the buffer layer. Therefore, the first thin film transistor and the second thin film transistor can be combined with the substrate more steadily; in addition, harmful impurities and ions in the substrate can be prevented from spreading to the first thin film transistor and the second thin film transistor, to avoid affecting performance of the first thin film transistor and the second thin film transistor.

According to a second aspect, a liquid crystal display panel is provided, including the array board in the first aspect, and further including a color film substrate and a liquid crystal layer disposed between the array board and the color film substrate. The liquid crystal display panel achieves same technical effects as those achieved in the first aspect, and details are not described herein again.

According to a third aspect, a production method of an array board is provided, where the method includes: successively forming a first thin film transistor, a pixel electrode, and a common electrode on a substrate in each subpixel region, where the pixel electrode is electrically connected to a drain electrode of the first thin film transistor by using a via hole; and the production method of an array board further includes: further forming, in each subpixel region, an auxiliary electrode at the via hole that connects the pixel electrode and the drain electrode of the first thin film transistor, where the auxiliary electrode is located between the pixel electrode and the drain electrode of the first thin film transistor, and the pixel electrode is electrically connected to the drain electrode of the first thin film transistor by using the auxiliary electrode, where an orthographic projection of the common electrode on the substrate and an orthographic projection of the pixel electrode on the substrate do not overlap at the via hole that connects the pixel electrode and the drain electrode of the first thin film transistor. The method achieves same technical effects as those achieved by the array board in the first aspect, and details are not described herein again.

Further, the first thin film transistor is a low-temperature polycrystalline silicon thin film transistor. Therefore, a liquid crystal display panel including the array board can have advantages such as high mobility, a high reaction speed, high resolution, high luminance, and a high aperture ratio.

In a first possible implementation of the third aspect, the production method of an array board further includes: forming a second thin film transistor on the substrate in each subpixel region, where the first thin film transistor and the second thin film transistor are low-temperature polycrystalline silicon thin film transistors and are connected in series, and the second thin film transistor and the first thin film transistor are synchronously formed. Two low-temperature polycrystalline silicon thin film transistors that are connected in series are disposed in each subpixel to drive the pixel electrode, so that driving performance of each subpixel can be improved.

With reference to the first possible implementation of the third aspect, in a second possible implementation of the third aspect, the first thin film transistor includes a first active layer, and the second thin film transistor includes a second active layer; the first active layer and the second active layer each include a source electrode region, a channel region, and a drain electrode region, and in this embodiment of the present invention, the source electrode region of the first active layer is connected to the drain electrode region of the second active layer; and the drain electrode of the first thin film transistor is in contact with the drain electrode region of the first active layer, a source electrode of the second thin film transistor is in contact with the source electrode region of the second active layer, and the source electrode of the second thin film transistor is electrically connected to a data line. Compared with a case in which a drain electrode of the second thin film transistor is electrically connected to a source electrode of the first thin film transistor (that the drain electrode of the second thin film transistor is connected to the source electrode of the first thin film transistor is only for transmitting, to the drain electrode of the first thin film transistor, a signal on the data line electrically connected to the source electrode of the second thin film transistor), in this embodiment of the present invention, the source electrode region of the first active layer is connected to the drain electrode region of the second active layer, so that the signal on the data line electrically connected to the source electrode of the second thin film transistor can be directly transmitted to the drain electrode of the first thin film transistor by using the first active layer and the second active layer that are connected, without producing the drain electrode of the second thin film transistor and the source electrode of the first thin film transistor. In this way, a production technology can be simplified, and costs are reduced.

With reference to the second possible implementation of the third aspect, in a third possible implementation of the third aspect, the first thin film transistor includes a first gate electrode, and the second thin film transistor includes a second gate electrode; and the first gate electrode is electrically connected to the second gate electrode. Therefore, the second thin film transistor and the first thin film transistor can be enabled at the same time, and line arrangement and a drive circuit on the array board can be simplified.

With reference to any one of the foregoing possible implementations, in a fourth possible implementation of the third aspect, the production method of an array board further includes: forming a touch electrode and a touch electrode lead electrically connected to the touch electrode, where the touch electrode lead and the auxiliary electrode are synchronously formed, and the auxiliary electrode and the touch electrode lead are insulated from each other. The touch electrode and the touch electrode lead electrically connected to the touch electrode are formed on the array board, so that when the array board is applied to a liquid crystal display panel, the liquid crystal display panel can have a touch function. On a basis of this, the touch electrode lead and the auxiliary electrode are synchronously formed, so that a quantity of times of using a pattern forming technology can be reduced.

Further, the touch electrode includes a drive electrode and an induction electrode. The drive electrode extends in a first direction, the induction electrode extends in a second direction, and the first direction and the second direction are crossed. A touch electrode lead electrically connected to the drive electrode is configured to provide a touch drive signal for the drive electrode, and a touch electrode lead electrically connected to the induction electrode is configured to receive a touch induction signal induced by the induction electrode. In this way, a touch position can be identified in a mutual-capacitance manner.

Alternatively, touch electrodes are arranged into an array, and the touch electrode lead electrically connected to the touch electrode provides a touch drive signal for the touch electrode, and receives a touch induction signal induced by the touch electrode. In this way, a touch position can be identified in a self-capacitance manner.

With reference to the fourth possible implementation of the third aspect, in a fifth possible implementation of the third aspect, the touch electrode and the common electrode are interchangeable. In this way, the touch position can be identified in a self-capacitance manner, and a technology of producing the array board is simpler.

### BRIEF DESCRIPTION OF DRAWINGS

FIG. 1 is a first schematic top view of an array board according to an embodiment of the present invention;
FIG. 2 is a schematic sectional view in an AA' direction in FIG. 1;
FIG. 3 is a schematic diagram existing when there is a common electrode at a via hole that is used to electrically connect a pixel electrode and a drain electrode;
FIG. 4 is a first schematic structural diagram of a first thin film transistor on an array board according to an embodiment of the present invention;
FIG. 5 is a second schematic structural diagram of a first thin film transistor on an array board according to an embodiment of the present invention;
FIG. 6 is a second schematic top view of an array board according to an embodiment of the present invention;
FIG. 7 is a first schematic sectional view in a BB' direction in FIG. 6;
FIG. 8 is a second schematic sectional view in a BB' direction in FIG. 7;
FIG. 9A and FIG. 9B are a schematic flowchart of a production method of an array board according to an embodiment of the present invention;
FIG. 10a is a schematic diagram of a process of forming a buffer layer, a first active layer, and a second active layer on a substrate in a production method process according to an embodiment of the present invention;
FIG. 10b is a schematic sectional view in a CC' direction in FIG. 10a;
FIG. 11a is a schematic diagram of a process of forming a gate insulation layer, a first gate electrode, and a second gate electrode on a basis of FIG. 10a;
FIG. 11b is a first schematic sectional view in a DD' direction in FIG. 11a;
FIG. 11c is a second schematic sectional view in a DD' direction in FIG. 11a;
FIG. 12a is a schematic diagram of a process of forming an inter-layer insulation layer, a source electrode of a second thin film transistor, a data line, and a drain electrode of a first thin film transistor on a basis of FIG. 11a;
FIG. 12b is a schematic sectional view in an EE' direction in FIG. 12a;
FIG. 13a is a schematic diagram of a process of forming, on a basis of FIG. 12a, a first insulation layer that includes a first via hole;
FIG. 13b is a schematic sectional view in an FF' direction in FIG. 13a;
FIG. 14a is a schematic diagram of a process of forming an auxiliary electrode on a basis of FIG. 13a;
FIG. 14b is a schematic sectional view in a GG' direction in FIG. 14a; and
FIG. 14c is a schematic diagram of a process of forming, on a basis of FIG. 14b, a second insulation layer that includes a second via hole.

### Reference numerals:

10: Subpixel; 20: Substrate; 30: First thin film transistor; 40: Pixel electrode; 50: Common electrode; 60: Via hole; 70: Auxiliary electrode; 80: Second thin film transistor; 90: Buffer layer; 301: Drain electrode of the first thin film transistor; 302: First active layer; 303: Gate insulation layer; 304: First gate electrode; 305: Inter-layer insulation layer; 308: Source electrode of the first thin film transistor; 3021: Channel region; 3022: Source electrode region; 3023: Drain electrode region; 3024: Lightly doped region; 3025: Heavily doped region; 801: Source electrode of the second thin film transistor; 802: Second active layer; 803: Data line; 804: Second gate electrode; 805: Gate line; 200: First insulation layer; 201: First via hole; 202: Second insulation layer; 203: Second via hole.

### DESCRIPTION OF EMBODIMENTS

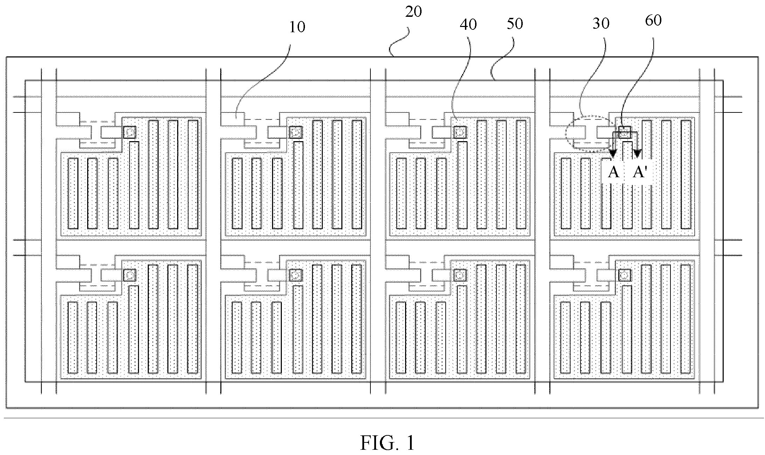

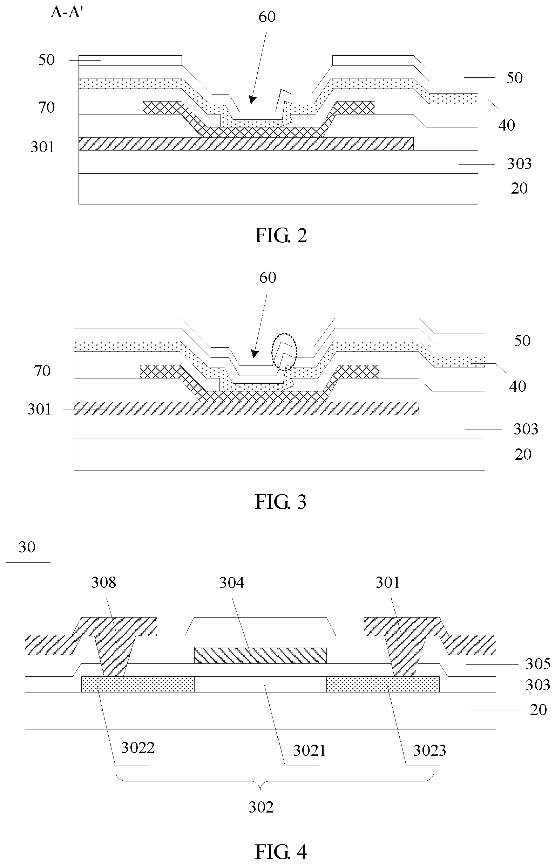

As shown in FIG. 1 and FIG. 2, an aspect of the present invention provides an array board, including a plurality of subpixels 10. Each subpixel 10 includes a first thin film transistor 30, a pixel electrode 40, and a common electrode 50 that are disposed on a substrate 20, and the pixel electrode 40 is electrically connected to a drain electrode 301 of the first thin film transistor by using a via hole 60. Each subpixel 10 further includes an auxiliary electrode 70 disposed at the via hole 60 that connects the pixel electrode 40 and the drain electrode 301 of the first thin film transistor. The auxiliary electrode 70 is disposed between the pixel electrode 40 and the drain electrode 301 of the first thin film transistor, and the pixel electrode 40 is electrically connected to the drain electrode 301 of the first thin film transistor by using the auxiliary electrode 70.

The common electrode 50 is disposed on one side that is of the pixel electrode 40 and that is away from the substrate 20, and an orthographic projection of the common electrode 50 on the substrate 20 and an orthographic projection of the pixel electrode 40 on the substrate 20 do not overlap at the via hole 60 that connects the pixel electrode 40 and the drain electrode 301 of the first thin film transistor.

It should be noted that, for the pixel electrode 40 and the common electrode 50, because the common electrode 50 is disposed on the side that is of the pixel electrode 40 and that is away from the substrate 20, the common electrode 50 needs to include a plurality of strip electrodes that are electrically connected, and the pixel electrode 40 may be disposed as a planar electrode.

If the common electrode 50 is disposed in a prior-art manner, a schematic diagram of the via hole 60 that connects the pixel electrode 40 and the drain electrode 301 of the first thin film transistor is shown in FIG. 3. A sharp corner in a dashed-line box shown in the figure causes a current leakage path between the pixel electrode 40 and the common electrode 50. However, in this aspect of the present invention, the orthographic projection of the common electrode 50 on the substrate 20 and the orthographic projection of the pixel electrode 40 on the substrate 20 do not overlap at the via hole 60 that connects the pixel electrode 40 and the drain electrode 301 of the first thin film transistor, to be specific, the common electrode 50 is removed from the via hole 60, so that a current leakage path can be avoided.

According to the array board provided in this aspect of the present invention, the pixel electrode 40 and the common electrode 50 are stacked on the array board, so that when the array board is applied to a liquid crystal display panel, the liquid crystal display panel can have advantages such as high resolution, high transmittance, low power consumption, a wide viewing angle, a high aperture ratio, low chromatic aberration, and no push mura. In addition, the orthographic projection of the common electrode 50 on the substrate 20 and the orthographic projection of the pixel electrode 40 on the substrate 20 do not overlap at the via hole 60 that connects the pixel electrode 40 and the drain electrode 301 of the first thin film transistor. Therefore, regardless of a technology change at the via hole 60, no current leakage path is generated because there is no common electrode 50 at the via hole 60, so that when the array board is applied to a liquid crystal display panel, display uniformity can be improved.

Based on the foregoing array board, a type of the first thin film transistor 30 may not be limited. For example, the first thin film transistor 30 may be an amorphous silicon thin film transistor, an oxide thin film transistor, a polycrystalline silicon thin film transistor, or the like.

Specifically, the type of the first thin film transistor 30 depends on a material of an active layer. When the material of the active layer is an amorphous silicon material, the first thin film transistor 30 is an amorphous silicon thin film transistor (as shown in FIG. 1 or FIG. 2).

When the material of the active layer is an oxide semiconductor material, the first thin film transistor 30 is an oxide thin film transistor (as shown in FIG. 1 or FIG. 2). For example, the oxide semiconductor material may include at least one of indium gallium zinc oxide (Indium Gallium Zinc Oxide, IGZO for short), indium zinc oxide (Indium Zinc Oxide, IZO for short), zinc oxide (ZnO), and gallium zinc oxide (Gallium Zinc Oxide, GZO for short). In addition, based on a production technology, the oxide thin film transistor may further fall into an oxide thin film transistor of a back-channel etching type and an oxide thin film transistor of an etching-stop type. Compared with the oxide thin film transistor of the back-channel etching type, the oxide thin film transistor of the etching-stop type includes an extra etching-stop layer disposed above an active layer.

When the material of the active layer is a polycrystalline silicon material, the first thin film transistor 30 is a polycrystalline silicon thin film transistor. Based on a polycrystalline silicon forming technology, the polycrystalline silicon thin film transistor may include a low-temperature polycrystalline silicon thin film transistor.

Therefore, the first thin film transistor 30 may be of a bottom-gate type or a top-gate type. The bottom-gate type is used as an example for illustration in FIG. 1 and FIG. 2.

The pixel electrode 40 and the common electrode 50 may be made of transparent conductive materials, which, for example, may be indium tin oxide (Indium Tin Oxides, ITO for short) or IZO.

For example, the auxiliary electrode 70 and another function pattern on the array board may be synchronously formed (or disposed on a same layer), namely, when the another function pattern is formed on the array board, the auxiliary electrode 70 may be formed at the via hole 60 that connects the pixel electrode 40 and the drain electrode 301 of the first thin film transistor. In this way, a quantity of times of using a pattern forming technology during array board production may not be increased. In this case, to avoid a short circuit between the another function pattern and the first thin film transistor 30, the pixel electrode 40, and the like, as shown in FIG. 2, the auxiliary electrode 70 may be electrically connected to the drain electrode 301 of the first thin film transistor by using a first via hole on a first insulation layer disposed between the auxiliary electrode 70 and the drain electrode 301 of the first thin film transistor, and the pixel electrode 40 may be electrically connected to the auxiliary electrode 70 by using a second via hole on a second insulation layer disposed between the pixel electrode 40 and the auxiliary electrode 70. The first via hole and the second via hole form the via hole 60 that is used to electrically connect the pixel electrode 40 and the drain electrode 301 of the first thin film transistor.

Certainly, if the quantity of times of using a pattern forming technology is not considered, and adding the auxiliary electrode 70 may ensure a yield rate obtained when the pixel electrode 40 is electrically connected to the drain electrode 301 of the first thin film transistor at the via hole 60, the auxiliary electrode 70 may be independently formed by using a pattern forming technology once.

A material of the auxiliary electrode 70 may be a metal conductive material or a transparent conductive material. This may be set based on an actual case.

Embodiment 1: As shown in FIG. 4, the first thin film transistor 30 on the array board is a low-temperature polycrystalline silicon (Low Temperature Poly-Silicon, LTPS for short) thin film transistor.

Therefore, a liquid crystal display panel including the array board can have advantages such as high mobility, a high reaction speed, high resolution, high luminance, and a high aperture ratio.

For example, as shown in FIG. 4, a structure of the first thin film transistor 30 may be as follows: A first active layer 302 is disposed nearby the substrate 20; the first active layer 302 may include a channel region 3021, a source electrode region 3022, and a drain electrode region 3023; a gate insulation layer 303, a first gate electrode 304, and an inter-layer insulation layer 305 are successively disposed on one side that is of the first active layer 302 and that is away from the substrate 20; and a source electrode 308 and the drain electrode 301 of the first thin film transistor are disposed on the inter-layer insulation layer 305, and are respectively in contact with in this embodiment of the present invention, the source electrode region 3022 and the drain electrode region 3023 by using third via holes penetrating through the inter-layer insulation layer 305 and the gate insulation layer 303.

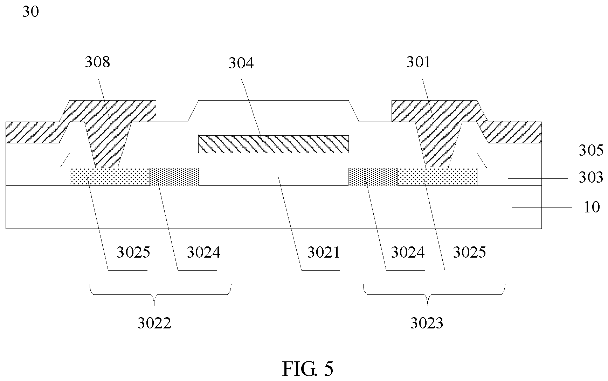

On a basis of this, to suppress current leakage, as shown in FIG. 5, the source electrode region 3022 and the drain electrode region 3023 each may include a lightly doped region 3024 and a heavily doped region 3025, and the lightly doped region 3024 is located between the heavily doped region 3025 and the channel region 3021. The source electrode 308 and the drain electrode 301 of the first thin film transistor are respectively in contact with the heavily doped regions 3025 on two sides of the channel region 3021.

Regardless of the structure of the first thin film transistor 30 shown in FIG. 4 or the structure of the first thin film transistor 30 shown in FIG. 5, when the subpixel includes only the first thin film transistor 30, the source electrode 308 of the first thin film transistor is electrically connected to a data line, the drain electrode 301 of the first thin film transistor is electrically connected to the pixel electrode 40 by using the auxiliary electrode 70, and the first gate electrode 304 is electrically connected to a gate line, or the first gate electrode 304 is included in a gate line (namely, the first gate electrode 304 is a part of the gate line).

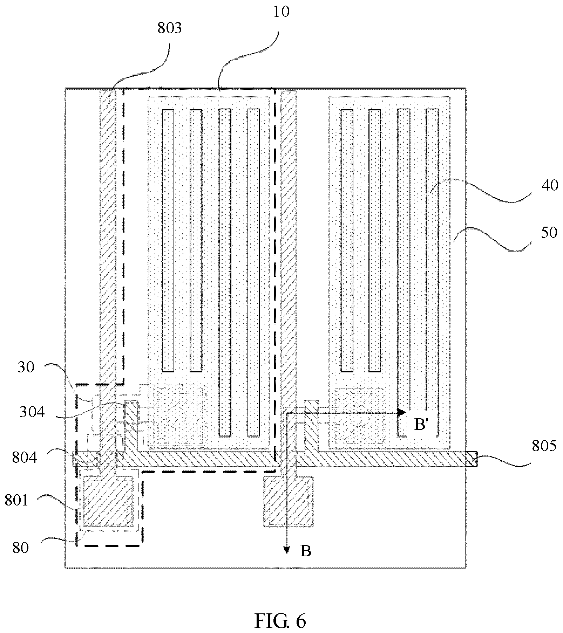

Embodiment 2: As shown in FIG. 6, each subpixel on the array board further includes a second thin film transistor 80, and the first thin film transistor 30 and the second thin film transistor 80 are low-temperature polycrystalline silicon thin film transistors.

The second thin film transistor 80 and the first thin film transistor 30 are connected in series.

It should be noted that, when the second thin film transistor 80 and the first thin film transistor 30 are connected in series, because the drain electrode 301 of the first thin film transistor is electrically connected to the pixel electrode 40, a source electrode 801 of the second thin film transistor needs to be electrically connected to a data line 803. In this way, a signal on the data line 803 can be transmitted to the drain electrode 301 of the first thin film transistor by using the second thin film transistor 80 and the first thin film transistor 30 that are connected in series, and then transmitted to the pixel electrode 40 by using the drain electrode 301 of the first thin film transistor.

Therefore, two low-temperature polycrystalline silicon thin film transistors that are connected in series are disposed in each subpixel 10 to drive the pixel electrode 40, so that driving performance of each subpixel 10 can be improved.

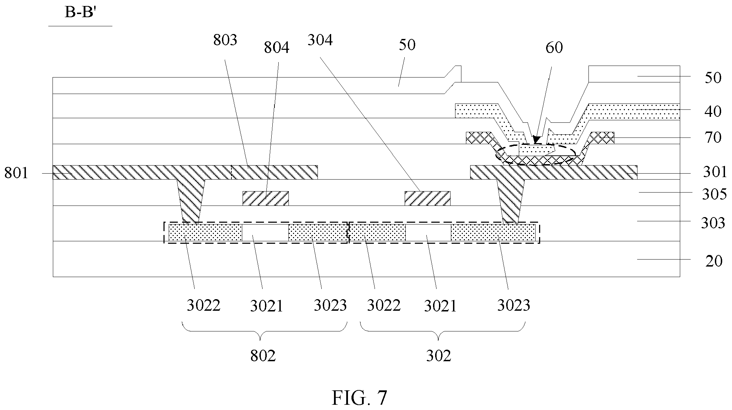

Embodiment 3: As shown in FIG. 6 and FIG. 7, in each subpixel 10 on the array board, on a basis of a fact that the first thin film transistor 30 and the second thin film transistor 80 are low-temperature polycrystalline silicon thin film transistors, the first thin film transistor 30 includes the first active layer 302, and the second thin film transistor 80 includes a second active layer 802. The first active layer 302 and the second active layer 802 each include the channel region 3021, in this embodiment of the present invention, the source electrode region 3022, and the drain electrode region 3023. The source electrode region 3022 of the first active layer 302 is connected to the drain electrode region 3023 of the second active layer 802.

The drain electrode 301 of the first thin film transistor is in contact with the drain electrode region 3023 of the first active layer 302, the source electrode 801 of the second thin film transistor is in contact with in this embodiment of the present invention, the source electrode region 3022 of the second active layer 802, and the source electrode 801 of the second thin film transistor is electrically connected to the data line 803.

It should be noted that, that in this embodiment of the present invention, the source electrode region 3022 of the first active layer 302 is connected to the drain electrode region 3023 of the second active layer 802 may be as follows: The first active layer 302 and the second active layer 802 are formed integrally, so that in this embodiment of the present invention, the source electrode region 3022 of the first active layer 302 and the drain electrode region 3023 of the second active layer 802 are approaching and seamlessly connected.

On a basis of this, to suppress current leakage, in this embodiment of the present invention, the source electrode region 3022 and the drain electrode region 3023 each may include the lightly doped region 3024 and the heavily doped region 3025. Therefore, that in this embodiment of the present invention, the source electrode region 3022 of the first active layer 302 is connected to the drain electrode region 3023 of the second active layer 802 may be as follows: The heavily doped region 3025 of in this embodiment of the present invention, the source electrode region 3022 of the first active layer 302 is connected to the heavily doped region 3025 of the drain electrode region 3023 of the second active layer 802.

Compared with a case in which a drain electrode of the second thin film transistor 80 is electrically connected to the source electrode of the first thin film transistor 30 (that the drain electrode of the second thin film transistor 80 is connected to the source electrode of the first thin film transistor 30 is only for transmitting, to the drain electrode 301 of the first thin film transistor, the signal on the data line 803 electrically connected to the source electrode 801 of the second thin film transistor), in Embodiment 3, in this embodiment of the present invention, the source electrode region 3022 of the first active layer 302 is connected to the drain electrode region 3023 of the second active layer 802, so that the signal on the data line 803 electrically connected to the source electrode 801 of the second thin film transistor can be directly transmitted to the drain electrode 301 of the first thin film transistor by using the first active layer 302 and the second active layer 802 that are connected, without producing the drain electrode of the second thin film transistor 80 and the source electrode of the first thin film transistor 30. In this way, a production technology can be simplified, and costs are reduced.

On a basis of Embodiment 3, further, if the signal on the data line 803 needs to be transmitted to the drain electrode 301 of the first thin film transistor, it is necessary to ensure that the second thin film transistor 80 and the first thin film transistor 30 are enabled at the same time. Therefore, as shown in FIG. 6, when the first gate electrode 304 of the first thin film transistor is electrically connected to a second gate electrode 804 of the second transistor, the second thin film transistor 80 and the first thin film transistor 30 can be enabled at the same time, and line arrangement and a drive circuit on the array board can be simplified.

For technology simplification, the first gate electrode 304 and the second gate electrode 804 may be synchronously formed.

Therefore, the first gate electrode 304 and the second gate electrode 804 in a same subpixel may be electrically connected to a same gate line, and are synchronously formed. Alternatively, as shown in FIG. 6, one of the first gate electrode 304 and the second gate electrode 804 is a part of a gate line 805, the other is electrically connected to the gate line 805, and the first gate electrode 304 and the second gate electrode 804 are synchronously formed.

Based on the foregoing possible structures of the array board, in Embodiment 4, the array board further includes a touch electrode and a touch electrode lead electrically connected to the touch electrode. The touch electrode lead and the auxiliary electrode 70 are synchronously formed, and the auxiliary electrode 70 and the touch electrode lead are insulated from each other.

The touch electrode lead is configured to: provide a touch drive signal for the touch electrode and/or receive a touch induction signal.

Specifically, the touch electrode may identify a touch position in a mutual-capacitance manner. On a basis of this, the touch electrode may include a drive electrode and an induction electrode. The drive electrode extends in a first direction, the induction electrode extends in a second direction, and the first direction and the second direction are crossed. The touch drive signal is applied to the drive electrode row by row, the induction electrode receives the touch induction signal, and the touch position is determined based on a change of the signal on the induction electrode and the drive electrode to which the drive signal is applied.

Either of the drive electrode and the induction electrode may be disposed on the array board. When one of the drive electrode and the induction electrode is disposed on the array board, the other may be disposed on a color film substrate of a liquid crystal display panel to which the array board is applied.

Alternatively, the touch electrode may identify a touch position in a self-capacitance manner. On a basis of this, touch electrodes are arranged into an array. The touch drive signal is applied to the touch electrode, and the touch induction signal is received. The received touch induction signal changes with capacitance on the touch electrode at the touch position, so that the touch position can be determined.

It should be noted that, a specific position and manner for disposing the touch electrode are not limited, provided that when the array board is applied to a liquid crystal display panel, normal display of the liquid crystal display panel is not affected while the touch electrode can identify the touch position.

Considering that resistance of the metal conductive material is relatively small, materials of both the auxiliary electrode 70 and the touch electrode lead may be metal conductive materials.

On a basis of Embodiment 4, further, the touch electrode and the common electrode 50 may be interchangeable. In this case, the touch position can be identified only in a self-capacitance manner.

There may be a plurality of common electrodes 50 that are arranged into an array, and the common electrodes 50 are disposed in a plurality of subpixels for performing display and touching alternately.

In Embodiment 4, the touch electrode and the touch electrode lead electrically connected to the touch electrode are disposed on the array board, so that when the array board is applied to a liquid crystal display panel, the liquid crystal display panel can have a touch function. On a basis of this, the touch electrode lead and the auxiliary electrode 70 are synchronously formed, so that the quantity of times of using a pattern forming technology can be reduced.

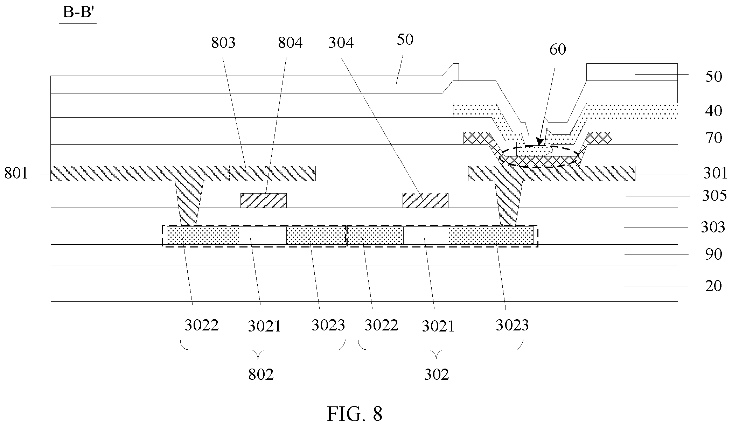

Based on the foregoing possible structures of the array board, in Embodiment 5, as shown in FIG. 8, the array board further includes a buffer layer 90 that is disposed on a surface, of the substrate 20, on which the first thin film transistor 30, the pixel electrode 40, and the common electrode 50 are disposed.

The buffer layer 90 may have a single-layer or multi-layer structure.

For example, when the buffer layer 90 has the single-layer structure, a material of the buffer layer 90 may be, for example, silicon oxide (SiOx) or silicon nitride (SiNx). When the buffer layer 90 has the structure including two or more layers, the buffer layer 90 may be a composite film layer of a silicon oxide layer and a silicon nitride layer.

The buffer layer 90 is disposed on the surface of the substrate 20 first, and then the first thin film transistor 30 or even the second thin film transistor 80 is disposed on the buffer layer 90. Therefore, the first thin film transistor 30 and the second thin film transistor 80 can be combined with the substrate 20 more steadily; in addition, harmful impurities and ions in the substrate 20 can be prevented from spreading to the first thin film transistor 30 and the second thin film transistor 80, to avoid affecting performance of the first thin film transistor 30 and the second thin film transistor 80.

Another aspect of the present invention provides a liquid crystal display panel, including the array board having any one of the foregoing structures, and further including a color film substrate and a liquid crystal layer disposed between the array board and the color film substrate.

The color film substrate may include a color filter layer and a black matrix. The color filter layer may include a first-color filter pattern, a second-color filter pattern, and a third-color filter pattern. The first-color filter pattern, the second-color filter pattern, and the third-color filter are in a one-to-one correspondence with three subpixels in one pixel on the array board. First color, second color, and third color are red, green, and blue, or may be cyan, magenta, and yellow. In addition, the color filter layer may further include a white filter pattern, and the white filter pattern may be corresponding to another subpixel other than the foregoing three subpixels in the pixel on the array board.

It should be noted that, the color filter layer may also be disposed on the array board.

According to the liquid crystal display panel provided in the another aspect of the present invention, the pixel electrode 40 and the common electrode 50 are stacked on the array board, so that the liquid crystal display panel can have advantages such as high resolution, high transmittance, low power consumption, a wide viewing angle, a high aperture ratio, low chromatic aberration, and no push mura. In addition, the orthographic projection of the common electrode 50 on the substrate 20 and the orthographic projection of the pixel electrode 40 on the substrate 20 do not overlap at the via hole 60, of the array board, that connects the pixel electrode 40 and the drain electrode 301 of the first thin film transistor. Therefore, regardless of a technology change at the via hole 60, no current leakage path is generated because there is no common electrode 50 at the via hole 60, so that display uniformity of the display panel can be improved.

Still another aspect of the present invention provides a liquid crystal display apparatus, including the foregoing liquid crystal display panel.

The liquid crystal display apparatus may be specifically a product or a component having any display function, for example, a liquid crystal display, a liquid crystal display television, a digital photo frame, a mobile phone, or a tablet computer.

Yet another aspect of the present invention provides a production method of an array board. As shown in FIG. 1 and FIG. 2, the method includes: successively forming a first thin film transistor 30, a pixel electrode 40, and a common electrode 50 on a substrate 20 in a region of each subpixel 10. The pixel electrode 40 is electrically connected to a drain electrode 301 of the first thin film transistor by using a via hole 60. The production method further includes: further forming, in the region of each subpixel 10, an auxiliary electrode 70 at the via hole 60 that connects the pixel electrode 40 and the drain electrode 301 of the first thin film transistor. The auxiliary electrode 70 is located between the pixel electrode 40 and the drain electrode 301 of the first thin film transistor, and the pixel electrode 40 is electrically connected to the drain electrode 301 of the first thin film transistor by using the auxiliary electrode 70.

An orthographic projection of the common electrode 50 on the substrate 20 and an orthographic projection of the pixel electrode 40 on the substrate 20 do not overlap at the via hole 60 that connects the pixel electrode 40 and the drain electrode 301 of the first thin film transistor.

It should be noted that, for the pixel electrode 40 and the common electrode 50, because the common electrode 50 is formed on one side that is of the pixel electrode 40 and that is away from the substrate 20, the common electrode 50 needs to include a plurality of strip electrodes that are electrically connected, and the pixel electrode 40 may be formed into a planar electrode.

The orthographic projection of the common electrode 50 on the substrate 20 and the orthographic projection of the pixel electrode 40 on the substrate 20 do not overlap at the via hole 60 that connects the pixel electrode 40 and the drain electrode 301 of the first thin film transistor, to be specific, when the common electrode 50 is formed, a part that is of the common electrode 50 and is located at the via hole 60 is removed.

In the production method of an array board provided in the yet another aspect of the present invention, the pixel electrode 40 and the common electrode 50 are formed on the array board, and the common electrode 50 is formed on the side that is of the pixel electrode 40 and that is away from the substrate 20, so that when the array board is applied to a liquid crystal display panel, the liquid crystal display panel can have advantages such as high resolution, high transmittance, low power consumption, a wide viewing angle, a high aperture ratio, low chromatic aberration, and no push mura. In addition, the orthographic projection of the common electrode 50 on the substrate 20 and the orthographic projection of the pixel electrode 40 on the substrate 20 do not overlap at the via hole 60 that connects the pixel electrode 40 and the drain electrode 301 of the first thin film transistor. Therefore, regardless of a technology change at the via hole 60, no current leakage path is generated because there is no common electrode 50 at the via hole 60, so that when the array board is applied to a liquid crystal display panel, display uniformity can be improved.

Based on the foregoing production method of an array board, when the first thin film transistor 30 is formed, different types of thin film transistors may be formed based on a requirement, for example, an amorphous silicon thin film transistor, an oxide thin film transistor, and a polycrystalline silicon thin film transistor. Therefore, the first thin film transistor 30 may be of a bottom-gate type or a top-gate type.

The pixel electrode 40 and the common electrode 50 may be made of transparent conductive materials, which, for example, may be ITO or IZO.

For example, the auxiliary electrode 70 and another function pattern on the array board may be synchronously formed, namely, when the another function pattern is formed on the array board, the auxiliary electrode 70 may be formed at the via hole 60 that electrically connects the pixel electrode 40 and the drain electrode 301 of the first thin film transistor. In this way, a quantity of times of using a pattern forming technology during array board production may not be increased. In this case, to avoid a short circuit between the another function pattern and the first thin film transistor 30, the pixel electrode 40, and the like, as shown in FIG. 2, the auxiliary electrode 70 may be electrically connected to the drain electrode 301 of the first thin film transistor by using a first via hole on a first insulation layer formed between the auxiliary electrode 70 and the drain electrode 301 of the first thin film transistor, and the pixel electrode 40 may be electrically connected to the auxiliary electrode 70 by using a second via hole on a second insulation layer formed between the pixel electrode 40 and the auxiliary electrode 70. The first via hole and the second via hole form the via hole 60 that is used to electrically connect the pixel electrode 40 and the drain electrode 301 of the first thin film transistor.

A material of the auxiliary electrode 70 may be a metal conductive material or a transparent conductive material. This may be set based on an actual case.

Based on the foregoing descriptions of the production method of an array board, considering that a liquid crystal display apparatus including a low-temperature polycrystalline silicon thin film transistor has advantages such as high mobility, a high reaction speed, high resolution, high luminance, and a high aperture ratio, the first thin film transistor 30 may be a low-temperature polycrystalline silicon thin film transistor. For a structure of the first thin film transistor 30, refer to FIG. 4 and FIG. 5 and the related descriptions thereof. Details are not described herein again.

On a basis of this, as shown in FIG. 6, the production method of an array board further includes: forming a second thin film transistor 80 on the substrate 20 in each subpixel region. The first thin film transistor 30 and the second thin film transistor 80 are low-temperature polycrystalline silicon thin film transistors and are connected in series, and the second thin film transistor 80 and the first thin film transistor 30 are synchronously formed.

It should be noted that, when the second thin film transistor 80 and the first thin film transistor 30 are connected in series, because the drain electrode 301 of the first thin film transistor is electrically connected to the pixel electrode 40, a source electrode 801 of the second thin film transistor needs to be electrically connected to a data line 803. In this way, a signal on the data line 803 can be transmitted to the drain electrode 301 of the first thin film transistor by using the second thin film transistor 80 and the first thin film transistor 30 that are connected in series, and then transmitted to the pixel electrode 40 by using the drain electrode 301 of the first thin film transistor.

Therefore, two low-temperature polycrystalline silicon thin film transistors that are connected in series are formed in each subpixel 10 to drive the pixel electrode 40, so that driving performance of each subpixel 10 can be improved. In addition, the second thin film transistor 80 and the first thin film transistor 30 are synchronously formed, so that the quantity of times of using a pattern forming technology may not be increased, thereby reducing costs.

Further, as shown in FIG. 6 and FIG. 7, on a basis of a fact that the first thin film transistor 30 and the second thin film transistor 80 are low-temperature polycrystalline silicon thin film transistors, the first thin film transistor 30 includes a first active layer 302, and the second thin film transistor 80 includes a second active layer 802. The first active layer 302 and the second active layer 802 each include a channel region 3021, a source electrode region 3022, and a drain electrode region 3023. In this embodiment of the present invention, the source electrode region 3022 of the first active layer 302 is connected to the drain electrode region 3023 of the second active layer 802.

The drain electrode 301 of the first thin film transistor is in contact with the drain electrode region 3023 of the first active layer 302, the source electrode 801 of the second thin film transistor is in contact with the source electrode region 3022 of the second active layer 802, and the source electrode 801 of the second thin film transistor is electrically connected to the data line 803.

It should be noted that, that the source electrode region 3022 of the first active layer 302 is connected to the drain electrode region 3023 of the second active layer 802 may be as follows: The first active layer 302 and the second active layer 802 are formed integrally, so that the source electrode region 3022 of the first active layer 302 and the drain electrode region 3023 of the second active layer 802 are approaching and seamlessly connected.

On a basis of this, to suppress current leakage, the source electrode region 3022 and the drain electrode region 3023 each may include a lightly doped region 3024 and a heavily doped region 3025. Therefore, that the source electrode region 3022 of the first active layer 302 is connected to the drain electrode region 3023 of the second active layer 802 may be as follows: The heavily doped region 3025 of the source electrode region 3022 of the first active layer 302 is connected to the heavily doped region 3025 of the drain electrode region 3023 of the second active layer 802.

Compared with a case in which a drain electrode of the second thin film transistor 80 is electrically connected to the source electrode of the first thin film transistor 30 (that the drain electrode of the second thin film transistor 80 is connected to the source electrode of the first thin film transistor 30 is only for transmitting, to the drain electrode 301 of the first thin film transistor, the signal on the data line 803 electrically connected to the source electrode 801 of the second thin film transistor), the source electrode region 3022 of the first active layer 302 is connected to the drain electrode region 3023 of the second active layer 802, so that the signal on the data line 803 electrically connected to the source electrode 801 of the second thin film transistor can be directly transmitted to the drain electrode 301 of the first thin film transistor by using the first active layer 302 and the second active layer 802 that are connected, without producing the drain electrode of the second thin film transistor 80 and the source electrode of the first thin film transistor 30. In this way, a production technology can be simplified, and costs are reduced.

Further, if the signal on the data line 803 needs to be transmitted to the drain electrode 301 of the first thin film transistor, it is necessary to ensure that the second thin film transistor 80 and the first thin film transistor 30 are enabled at the same time. Therefore, as shown in FIG. 6, when a first gate electrode 304 of the first thin film transistor is electrically connected to a second gate electrode 804 of the second transistor, the second thin film transistor 80 and the first thin film transistor 30 can be enabled at the same time, and line arrangement and a drive circuit on the array board can be simplified.

For technology simplification, the first gate electrode 304 and the second gate electrode 804 may be synchronously formed.

Therefore, the first gate electrode 304 and the second gate electrode 804 in a same subpixel may be electrically connected to a same gate line, and are synchronously formed. Alternatively, as shown in FIG. 6, one of the first gate electrode 304 and the second gate electrode 804 is a part of a gate line 805, the other is electrically connected to the gate line 805, and the first gate electrode 304 and the second gate electrode 804 are synchronously formed.

Based on the foregoing possible production methods of an array board, the production method of an array board may further include: forming a touch electrode and a touch electrode lead electrically connected to the touch electrode. The touch electrode lead and the auxiliary electrode 70 are synchronously formed, and the auxiliary electrode 70 and the touch electrode lead are insulated from each other.

The touch electrode lead is configured to: provide a touch drive signal for the touch electrode and/or receive a touch induction signal.

When the touch electrode identifies a touch position in a mutual-capacitance manner, the touch electrode may include a drive electrode and an induction electrode. The drive electrode extends in a first direction, the induction electrode extends in a second direction, and the first direction and the second direction are crossed. When the touch electrode identifies a touch position in a self-capacitance manner, touch electrodes may be arranged into an array.

Further, the touch electrode and the common electrode 50 may be interchangeable. In this case, the touch position can be identified only in a self-capacitance manner.

The touch electrode and the touch electrode lead electrically connected to the touch electrode are formed on the array board, so that when the array board is applied to a liquid crystal display panel, the liquid crystal display panel can have a touch function. On a basis of this, the touch electrode lead and the auxiliary electrode 70 are synchronously formed, so that the quantity of times of using a pattern forming technology can be reduced.

Based on the foregoing possible production methods of an array board, as shown in FIG. 8, the production method of an array board may further include: before forming the first thin film transistor 30, forming a buffer layer 90 on a surface of the substrate 20. The first thin film transistor 30 is formed on one side that is of the buffer layer 90 and that is away from the substrate 20.

The buffer layer 90 is formed on the surface of the substrate 20 first, and then the first thin film transistor 30 or even the second thin film transistor 80 is formed on the buffer layer 90. Therefore, the first thin film transistor 30 and the second thin film transistor 80 can be combined with the substrate 20 more steadily; in addition, harmful impurities and ions in the substrate 20 can be prevented from spreading to the first thin film transistor 30 and the second thin film transistor 80, to avoid affecting performance of the first thin film transistor 30 and the second thin film transistor 80.

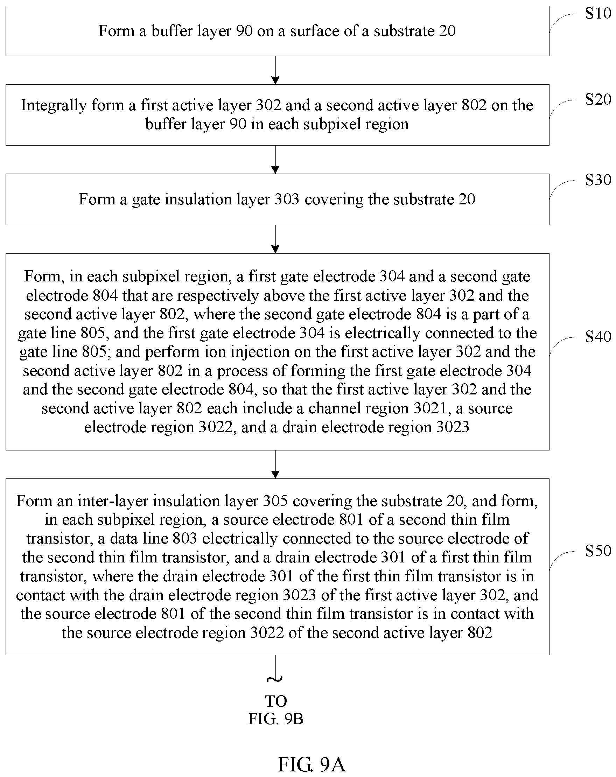

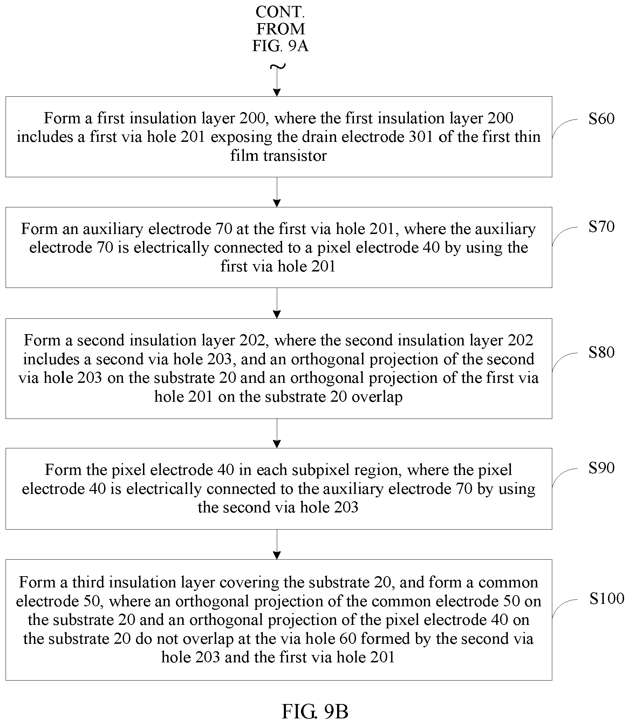

The following provides a specific embodiment to describe a production method of an array board in detail. As shown in FIG. 9A and FIG. 9B, the production method of an array board includes the following steps.

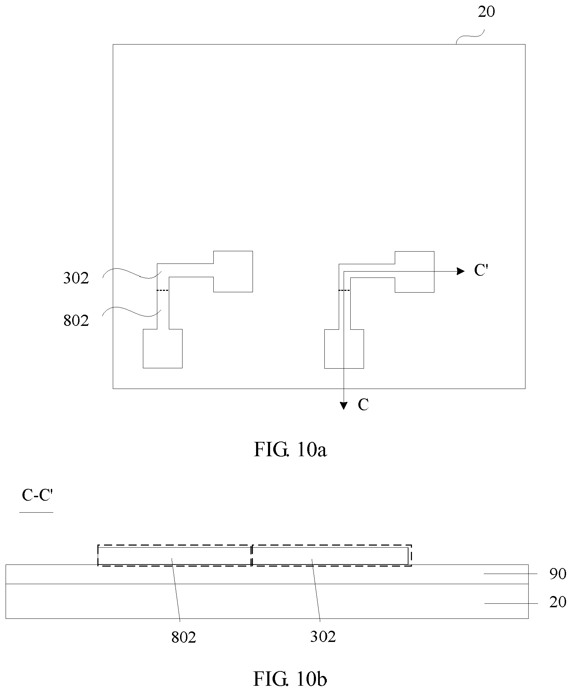

S10. As shown in FIG. 10a and FIG. 10b, form a buffer layer 90 on a surface of a substrate 20.

The buffer layer 90 may have a single-layer or multi-layer structure. When the buffer layer 90 has the single-layer structure, a material of the buffer layer 90 may be, for example, silicon oxide or silicon nitride. When the buffer layer 90 has the structure including two or more layers, the buffer layer 90 may be a composite film layer of a silicon oxide layer and a silicon nitride layer.

S20. As shown in FIG. 10a and FIG. 10b, integrally form a first active layer 302 and a second active layer 802 on the buffer layer 90 in each subpixel region.

Specifically, a silicon thin film may be deposited on the substrate 20 on which the buffer layer 90 is formed, a polycrystalline thin film is formed through poly-crystallization processing, and the first active layer 302 and the second active layer 802 shown in FIG. 10a and FIG. 10b are formed by using a pattern forming technology once. The pattern forming technology includes steps such as masking, exposure, development, etching, and photoresist stripping.

For example, that a polycrystalline thin film is formed may be as follows: A layer of amorphous silicon thin film is deposited on the buffer layer 90 by using a plasma enhanced chemical vapor deposition (Plasma Enhanced Chemical Vapor Deposition, PECVD for short) method, and dehydrogenation technological processing is performed on the amorphous silicon thin film by using a high-temperature oven, to avoid hydrogen explosion in a crystallization process and reduce an effect of defect-mode density within the thin film after the crystallization. After the dehydrogenation technology is completed, a low-temperature polycrystalline silicon (Low Temperature Poly-Silicon, LTPS for short) technology process is performed, and crystallization processing is performed on the amorphous silicon thin film by using a crystallization method such as an excimer laser annealing (ELA) technology, a metal induced crystallization (MIC) technology, and a solid phase crystallization (SPC) technology, to form the polycrystalline silicon thin film on the buffer layer 90.

Alternatively, a silicon thin film may be deposited on the substrate 20 on which the buffer layer 90 is formed. A reserved pattern is first formed in a pre-determined region by using a pattern forming technology once, and then poly-crystallization processing is performed on the reserved pattern to form the first active layer 302 and the second active layer 802 shown in FIG. 10a and FIG. 10b.

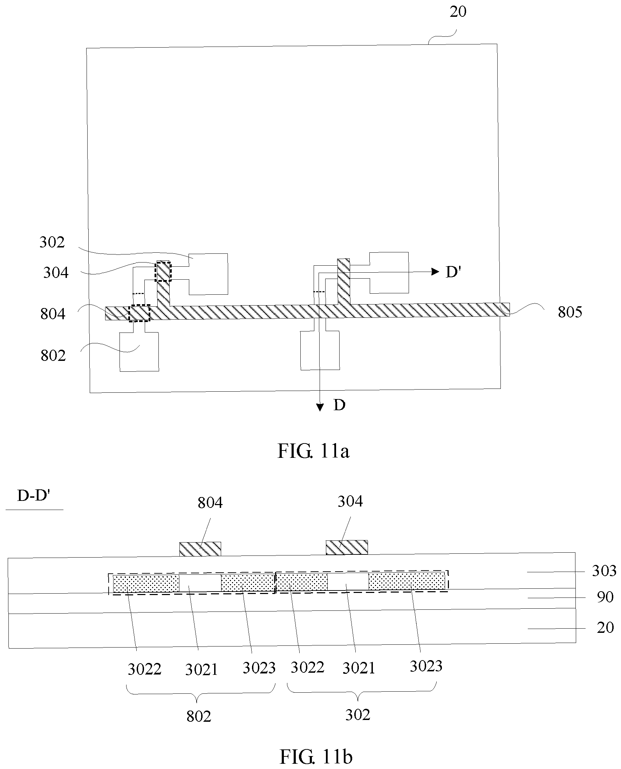

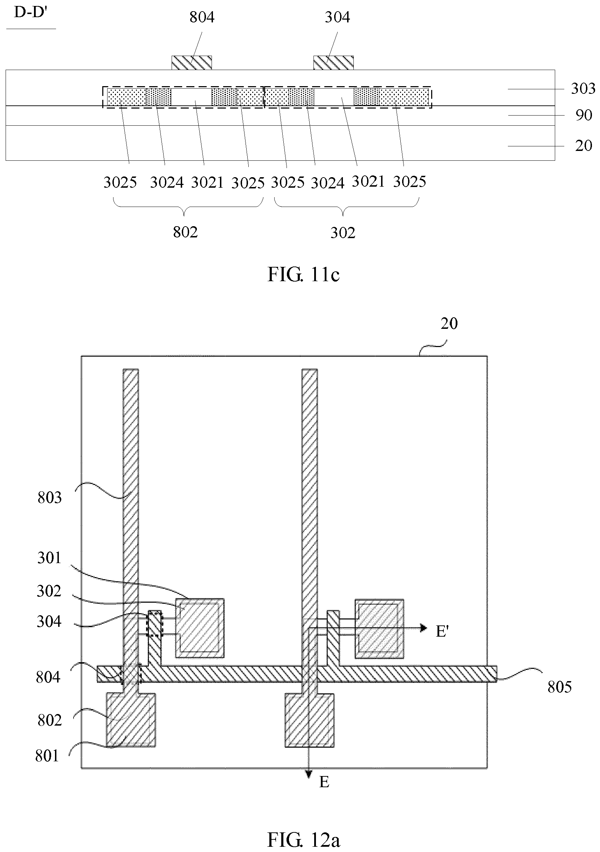

S30. As shown in FIG. 11a, FIG. 11b, and FIG. 11c, on a basis of S20, form a gate insulation layer 303 covering the substrate 20.

A material of the gate insulation layer 303 may include either of silicon oxide and silicon nitride.

S40. As shown in FIG. 11a, FIG. 11b, and FIG. 11c, on a basis of S30, form, in each subpixel region, a first gate electrode 304 and a second gate electrode 804 that are respectively above the first active layer 302 and the second active layer 802, where the second gate electrode 804 is a part of a gate line 805, and the first gate electrode 304 is electrically connected to the gate line 805; and perform ion injection on the first active layer 302 and the second active layer 802 in a process of forming the first gate electrode 304 and the second gate electrode 804, so that the first active layer 302 and the second active layer 802 each include a channel region 3021, a source electrode region 3022, and a drain electrode region 3023.

Specifically, as shown in FIG. 11b, when the source electrode region 3022 and the drain electrode region 3023 each do not include a lightly doped region 3024 and a heavily doped region 3025, after the first gate electrode 304 and the second gate electrode 804 are formed, ion injection may be performed on the first active layer 302 and the second active layer 802 as the first gate electrode 304 and the second gate electrode 804 block ion injection, so that the first active layer 302 and the second active layer 802 each include the channel region 3021, and the source electrode region 3022 and the drain electrode region 3023 that are on two sides of the channel region 3021. The first gate electrode 304 is corresponding to the channel region 3021 of the first active layer 302, the second gate electrode 804 is corresponding to the channel region 3021 of the second active layer 802, and the source electrode region 3022 of the first active layer 302 and the drain electrode region 3023 of the second active layer 802 are connected as a whole.

As shown in FIG. 11c, when the source electrode region 3022 and the drain electrode region 3023 each include a lightly doped region 3024 and a heavily doped region 3025, when the first gate electrode 304 and the second gate electrode 804 are formed, a photoresist may be exposed, for example, by using a half-tone mask plate, so that a fully reserved part of the photoresist is corresponding to the first gate electrode 304 and the second gate electrode 804, and a half reserved part of the photoresist is corresponding to to-be-formed lightly doped regions 3024 in the first active layer 302 and the second active layer 802. In this way, after the photoresist is developed, ion injection may be first performed on the exposed first active layer 302 and second active layer 802, to form the heavily doped regions 3025. Then, an ashing technology is performed to remove the half reserved part of the photoresist, and an exposed gate metal thin film is etched, to form the first gate electrode 304 and the second gate electrode 804. Next, ion injection is performed on the exposed first active layer 302 and second active layer 802 as the first gate electrode 304 and the second gate electrode 804 block ion injection. Therefore, in addition to the heavily doped region 3025 and the channel region 3021 corresponding to the first gate electrode 304 and the second gate electrode 804, the lightly doped region 3024 is formed on each of the first active layer 302 and the second active layer 802.

A material of each of the first gate electrode 304 and the second gate electrode 804 may be, for example, molybdenum (Mo), aluminum (Al)/molybdenum, or copper (Cu).

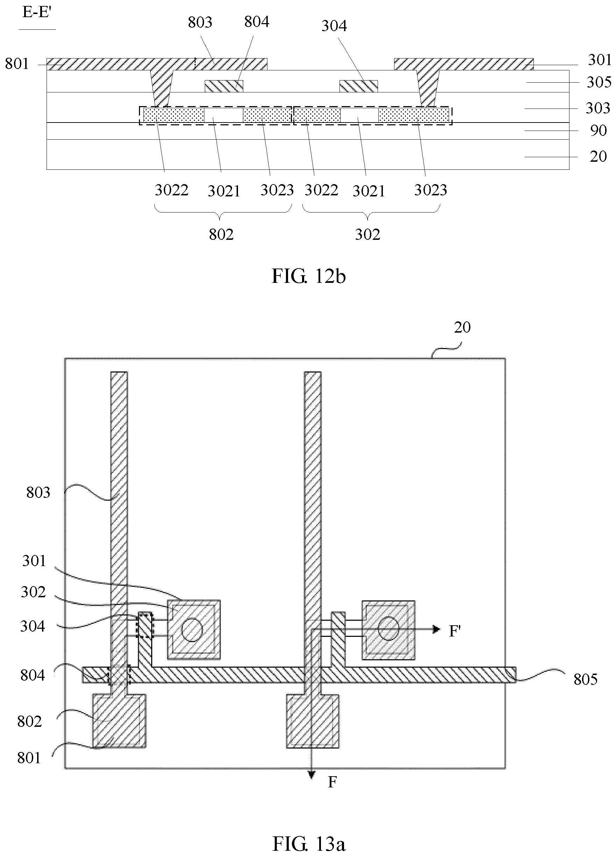

S50. As shown in FIG. 12a and FIG. 12b, on a basis of S40, form an inter-layer insulation layer 305 covering the substrate 20, and form, in each subpixel region, a source electrode 801 of a second thin film transistor, a data line 803 electrically connected to the source electrode of the second thin film transistor, and a drain electrode 301 of a first thin film transistor, where the drain electrode 301 of the first thin film transistor is in contact with the drain electrode region 3023 of the first active layer 302, and the source electrode 801 of the second thin film transistor is in contact with the source electrode region 3022 of the second active layer 802.

A material of each of the source electrode 801 of the second thin film transistor, the data line 803, and the drain electrode 301 of the first thin film transistor may be, for example, Mo, Al/Mo, or Cu.

When the source electrode region 3022 and the drain electrode region 3023 each include the lightly doped region 3024 and the heavily doped region 3025, the drain electrode 301 of the first thin film transistor is in contact with the heavily doped region 3025 of the first active layer 302, and the source electrode 801 of the second thin film transistor is in contact with the heavily doped region 3025 of the second active layer 802.

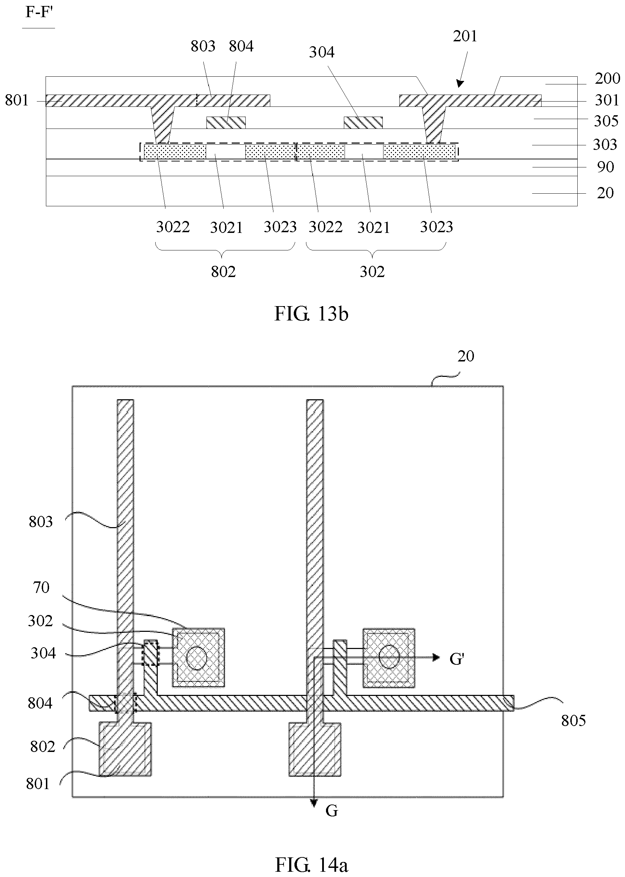

S60. As shown in FIG. 13a and FIG. 13b, on a basis of S50, form a first insulation layer 200, where the first insulation layer 200 includes a first via hole 201 exposing the drain electrode 301 of the first thin film transistor.

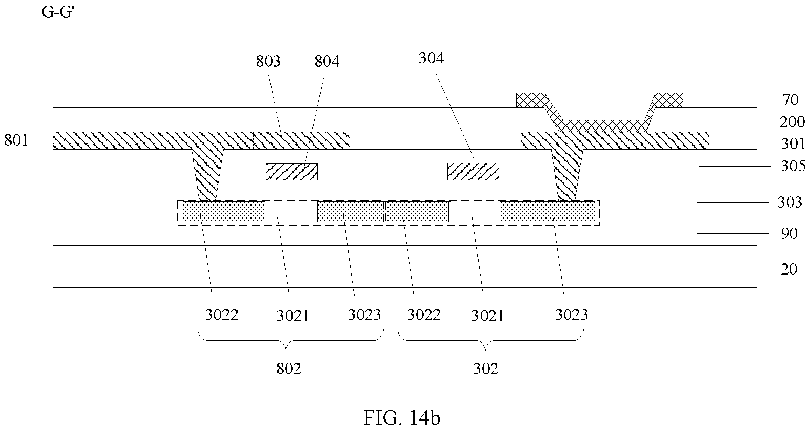

S70. As shown in FIG. 14a and FIG. 14b, on a basis of S60, form an auxiliary electrode 70 at the first via hole 201, where the auxiliary electrode 70 is electrically connected to a pixel electrode 40 by using the first via hole 201.

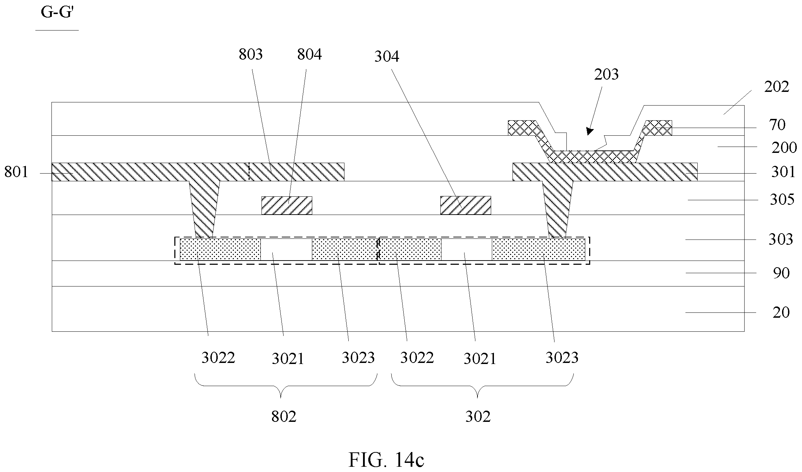

S80. As shown in FIG. 14c, on a basis of S70, form a second insulation layer 202, where the second insulation layer 202 includes a second via hole 203, and an orthogonal projection of the second via hole 203 on the substrate 20 and an orthogonal projection of the first via hole 201 on the substrate 20 overlap.

The second via hole 203 and the first via hole 201 form the foregoing via hole 60.

S90. As shown in FIG. 6 and FIG. 8, on a basis of S80, form the pixel electrode 40 in each subpixel region, where the pixel electrode 40 is electrically connected to the auxiliary electrode 70 by using the second via hole 203.

S100. As shown in FIG. 6 and FIG. 8, on a basis of S90, form a third insulation layer covering the substrate 20, and form a common electrode 50, where an orthogonal projection of the common electrode 50 on the substrate 20 and an orthogonal projection of the pixel electrode 40 on the substrate 20 do not overlap at the via hole 60 formed by the second via hole 203 and the first via hole 201.

When the common electrode and a touch electrode are interchangeable, the common electrode is electrically connected to a touch electrode lead.

The foregoing descriptions are only specific implementations of the present invention, but are not intended to limit the protection scope of the present invention. Any variation or replacement within the technical scope disclosed in the present invention shall fall within the protection scope of the present invention. Therefore, the protection scope of the present invention shall be subject to the protection scope of the claims.

## Claims

1. An array board, comprising a plurality of subpixels, wherein each subpixel comprises a first thin film transistor, a pixel electrode, and a common electrode that are disposed on a substrate, and the pixel electrode is electrically connected to a drain electrode of the first thin film transistor by using a via hole;
each subpixel further comprises an auxiliary electrode disposed at the via hole, wherein the auxiliary electrode is disposed between the pixel electrode and the drain electrode of the first thin film transistor, and the pixel electrode is electrically connected to the drain electrode of the first thin film transistor by using the auxiliary electrode; and
the common electrode is disposed on one side that is of the pixel electrode and that is away from the substrate, and an orthographic projection of the common electrode on the substrate and an orthographic projection of the pixel electrode on the substrate do not overlap at the via hole.

2. The array board according to claim 1, wherein the first thin film transistor is a low-temperature polycrystalline silicon thin film transistor.

3. The array board according to claim 2, wherein each subpixel further comprises a second thin film transistor, and the second thin film transistor is a low-temperature polycrystalline silicon thin film transistor; and
the second thin film transistor and the first thin film transistor are connected in series.

4. The array board according to claim 3, wherein the first thin film transistor comprises a first active layer, and the second thin film transistor comprises a second active layer;
the first active layer and the second active layer each comprise a source electrode region, a channel region, and a drain electrode region, and the source electrode region of the first active layer is connected to the drain electrode region of the second active layer; and
the drain electrode of the first thin film transistor is in contact with the drain electrode region of the first active layer, a source electrode of the second thin film transistor is in contact with the source electrode region of the second active layer, and the source electrode of the second thin film transistor is electrically connected to a data line.

5. The array board according to claim 4, wherein the first thin film transistor comprises a first gate electrode, and the second thin film transistor comprises a second gate electrode; and
the first gate electrode is electrically connected to the second gate electrode.

6. The array board according to any one of claims 1 to 5, wherein the array board further comprises a touch electrode and a touch electrode lead electrically connected to the touch electrode; and
the touch electrode lead and the auxiliary electrode are synchronously formed, and the auxiliary electrode and the touch electrode lead are insulated from each other.

7. The array board according to claim 6, wherein the touch electrode and the common electrode are interchangeable.

8. The array board according to any one of claims 1 to 7, wherein the array board further comprises a buffer layer that is disposed on a surface, of the substrate, on which the first thin film transistor, the pixel electrode, and the common electrode are disposed.

9. A liquid crystal display panel, comprising the array board according to any one of claims 1 to 8, and further comprising a color film substrate and a liquid crystal layer disposed between the array board and the color film substrate.

10. A production method of an array board, wherein the method comprises: successively forming a first thin film transistor, a pixel electrode, and a common electrode on a substrate in each subpixel region, wherein the pixel electrode is electrically connected to a drain electrode of the first thin film transistor by using a via hole; and
the production method further comprises: further forming an auxiliary electrode at the via hole in each subpixel region, wherein the auxiliary electrode is located between the pixel electrode and the drain electrode of the first thin film transistor, and the pixel electrode is electrically connected to the drain electrode of the first thin film transistor by using the auxiliary electrode, wherein
an orthographic projection of the common electrode on the substrate and an orthographic projection of the pixel electrode on the substrate do not overlap at the via hole.

11. The production method according to claim 10, wherein the method further comprises: forming a second thin film transistor on the substrate in each subpixel region, wherein
the first thin film transistor and the second thin film transistor are low-temperature polycrystalline silicon thin film transistors and are connected in series, and the second thin film transistor and the first thin film transistor are synchronously formed.

12. The production method according to claim 11, wherein the first thin film transistor comprises a first active layer, and the second thin film transistor comprises a second active layer;
the first active layer and the second active layer each comprise a source electrode region, a channel region, and a drain electrode region, and the source electrode region of the first active layer is connected to the drain electrode region of the second active layer; and
the drain electrode of the first thin film transistor is in contact with the drain electrode region of the first active layer, a source electrode of the second thin film transistor is in contact with the source electrode region of the second active layer, and the source electrode of the second thin film transistor is electrically connected to a data line.

13. The production method according to claim 12, wherein the first thin film transistor comprises a first gate electrode, and the second thin film transistor comprises a second gate electrode; and
the first gate electrode is electrically connected to the second gate electrode.

14. The production method according to claim 10, wherein the method further comprises: forming a touch electrode and a touch electrode lead electrically connected to the touch electrode, wherein
the touch electrode lead and the auxiliary electrode are synchronously formed, and the auxiliary electrode and the touch electrode lead are insulated from each other.
